# EUROPEAN PATENT SPECIFICATION

(11) **EP 3 214 657 B1**
(45) Date of publication and mention of the grant of the patent: **29.01.2020**
(21) Application number: 16177032.6
(22) Date of filing: 30.06.2016
(51) Int. Cl.: H01L 31/042, H01L 31/048, H01L 31/0445

(54) **SOLAR PANEL MODULE**
SOLARPANEELMODUL
MODULE DE PANNEAU SOLAIRE

(30) Priority: 03.03.2016 TW 105106539
(43) Date of publication of application: 06.09.2017
(73) Proprietor: Eterbright Solar Corporation, Toufen City, Miaoli County (TW)
(72) Inventor: HUANG, TING-HUI, Miaoli County 35154 (TW); Ku, Wei-Lun, Miaoli County 35154 (TW)
(74) Representative: Straus, Alexander

(56) References cited:
- WO-A2-2015/183827
- US-A1- 2011 197 951
- US-A1- 2012 037 203
- US-A1- 2013 206 210

## Description

### FIELD OF THE INVENTION

The present invention relates to a power module, and more particularly to a solar panel module.

### BACKGROUND OF THE INVENTION

Solar cell is a green energy source used extensively in our daily life, and the solar cell generally requires the installation of a large quantity of solar panels. A common configuration of the solar panels is to arrange the solar panels in a solar cell module, and a transparent encapsulation material is provided for connecting and fixing two adjacent solar panels. However, the solar panels in the solar cell are dark objects, so that heat is absorbed easily. During the operation of the solar cell, the degree of heat absorption of the transparent encapsulation material disposed between two adjacent solar panels is significantly different from the degree of heat absorption of the solar panels. Specifically, the significant different degree of heat absorption results in a non-uniform thermal stress in certain parts of the solar cell, and thus deteriorating or peeling off the solar panels and affecting the reliability of the solar cell.

In particular, the conventional solar panel comes with a specific structural thickness and the transparent encapsulation material disposed between two adjacent solar panels also has a large filling space as well as a large filling volume. Therefore, the non-uniform thermal stress between the transparent encapsulation material with a large filling volume and the solar panel is more significant under thermal expansion and contraction, and the service life of the solar cell is reduced substantially.

US 2013/206210 A1 discloses a solar panel module, comprising at least two solar panels sandwiched between a cover and a back plate and having a separating gap, wherein a dark insulating layer is provided in the separating gap.

### SUMMARY OF THE INVENTION

It is a primary objective of the present invention to provide a solar panel module with better structural reliability and longer service life.

To achieve the aforementioned and other objectives, the present invention provides a solar panel module comprising a cover, a back plate, at least two solar panels sandwiched between the cover and the back plate and arranged along a direction, and having a separating gap of a width formed between two adjacent solar panels; a first dark insulating layer, disposed in the separating gap and contacting an upper edge of one of the two adjacent solar panels without contacting the other one of the two adjacent solar panels; a second dark insulating layer, disposed in the separating gap and contacting a lower edge of the other one of the two adjacent solar panels without contacting the one of the two adjacent solar panels, wherein the first and second dark insulating layers have a color substantially the same as a color of the two adjacent solar panels, wherein the first and second dark insulating layers are partially overlapped with each other and each of the first and second dark insulating layers has a width greater than a half of the width of the separating gap.

In an embodiment of the present invention, the dark insulating layer is overlapped with at least a portion of the edge of one of the solar panels.

In an embodiment of the present invention, the dark insulating layer is extended from an edge of one of the solar panels to the separating gap by a distance, and the distance extended to the separating gap is greater than half of the width of the separating gap.

In an embodiment of the present invention, the dark insulating layer is overlapped with one of an upper edge and a lower edge of a corresponsive solar panel.

In an embodiment of the present invention, the solar panels are thin-film solar panels made of silicon (Si), cadmium telluride (CdTe), copper indium gallium selenium (CIGS) or any combination of the above.

In an embodiment of the present invention, the dark insulating layer is a transparent encapsulation material mixed with a dark insulator.

In an embodiment of the present invention, the heat absorption degree of the dark insulating layer is substantially the same as the heat absorption degree of the solar panel.

In an embodiment of the present invention, the cover and the back plate are glass plates.

In an embodiment of the present invention, the solar panel module further comprises a transparent encapsulation material filled in the separating gap, and two portions of the transparent encapsulation material disposed on two opposite edges of the dark insulating layer respectively have substantially the same volume.

In summation, the present invention has at least a dark insulating layer disposed between two adjacent solar panels, wherein the dark insulating layer comes with a color substantially the same as the color of the solar panel.

Therefore, the dark insulating layer disposed between two adjacent solar panels comes with a degree of heat absorption substantially the same as the degree of heat absorption of the solar panel during the operation of the solar cell, and the solar cell will not be deteriorated by the non-uniform thermal stress. Unlike the conventional solar panel module, the solar panel module of the present invention does not have the issues of poor attachment or peeling condition. In other words, the present invention has better structural connection and reliability and a longer service life.

The technical characteristics, contents, advantages and effects of the present invention will be apparent with the detailed description of a preferred embodiment accompanied with the illustration of related drawings as follows.

### BRIEF DESCRIPTION OF THE DRAWINGS

FIG. 1 is a schematic view of a solar panel module in accordance with a comparative example, not forming part of the present invention;
FIG. 2 is a schematic view of a solar panel module in accordance with another comparative example, not forming part of the present invention;
FIG. 3 is a schematic view of a solar panel module in accordance with a preferred embodiment of the present invention;
FIG. 4 is a schematic view of a solar panel module in accordance with a further preferred embodiment of the present invention; and
FIG. 5 is a schematic view of a solar panel module in accordance with a further comparative example, not forming part of the present invention.

### DESCRIPTION OF THE PREFERRED EMBODIMENTS

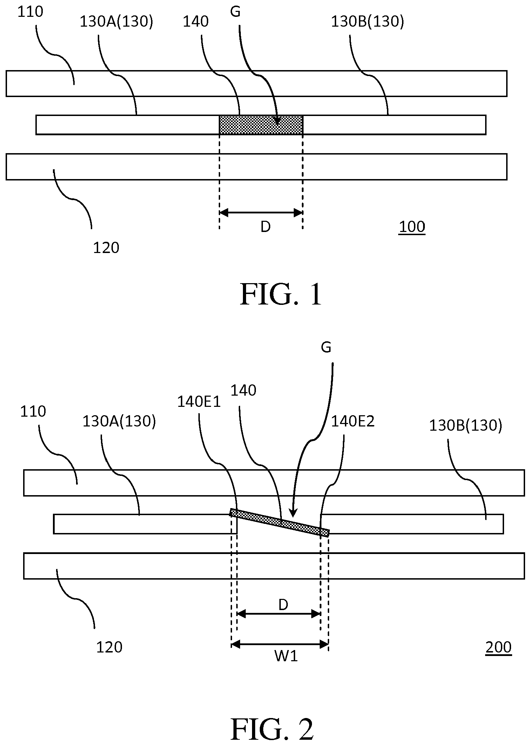

With reference to FIG. 1 for a schematic view of a solar panel module 100 in accordance with a comparative example, not forming part of the present invention, the solar panel module 100 comprises a cover 110, a back plate 120, at least two solar panels 130 and at least a dark insulating layer 140. In this embodiment, the cover 110 and the back plate 120 are glass plates sandwiching the solar panels 130 and are attached together by a transparent encapsulation material including a thermal encapsulant such as Ethylene Vinyl Acetate (EVA), polyolefin (PO), Polyethylene (PE) polyvinyl butyral (PVB), etc, an UV curable encapsulant, Silicone, or any combination of the above. In addition, there are two solar panels 130 in this embodiment, and these solar panels 130 are solar panels 130A and 130B configured between the cover 110 and the back plate 120 along a direction, so that a separating gap G exists between two adjacent solar panels 130A and 130B. Specifically, the two adjacent solar panels 130A and 130B are separated from each other by the separating gap having a width D. In addition, the dark insulating layer 140 is disposed in the separating gap G. The dark insulating layer may be a dark insulator made of Polyethylene (PE), Polyamide (PA), or Polyethylene terephthalate (PET) mixed with a color pigment, or a powder, a particle, or a film made of any combination of the abovementioned materials. Alternatively, the dark insulator may be mixed with a transparent encapsulation material including a thermal encapsulant such as Ethylene Vinyl Acetate (EVA), polyolefin (PO), Polyethylene (PE), polyvinyl butyral (PVB), etc, or UV curable encapsulant, or silicone, or any combination of the above, and filled in the separating gap G. The dark insulating layer may be a continuous insulator sheet sandwiched by the transparent encapsulation material disposed in the separating gap G and extended from the right side of the solar panel 130A to the left side of the solar panel 130B. This embodiment comes with two solar panels 130A, 130B, and thus there is only one separating gap G between the two adjacent solar panels 130. It is noteworthy that this embodiment is used for the purpose of illustration only, and the present invention is not limited to such embodiment.

In this embodiment, the solar panels 130A, 130B may be monocrystalline or polycrystalline solar panels. For example, the solar panels 130A, 130B are thin-film solar panels including silicon (Si), cadmium telluride (CdTe), copper indium gallium selenium (CIGS) or a combination of the above. Further, the solar panels 130A, 130B have a photoelectric conversion layer (not shown in the figure) for converting solar energy into electric energy. The photoelectric conversion layer is made of a semiconductor material including copper (Cu), indium (In), gallium (Ga) and selenium (Se), or a compound consisting of a Group Ib element such as copper (Cu) or silver (Ag), a Group IIIb element such as aluminum (Al), gallium (Ga) or indium (In), and a Group VIb element such as sulfur (S), selenium (Se) or tellurium (Te).

With reference to FIG. 2 for a schematic view of a solar panel module in accordance with another comparative example, not forming part of the present invention, the solar panel module 200 of this embodiment is substantially the same as the solar panel module 100 as shown in FIG. 1, except that the dark insulating layer 140 disposed in the separating gap G is overlapped with at least a portion of the edge of one of the two adjacent solar panels 130A, 130B in the solar panel module 200. In this embodiment, the dark insulating layer 140 overlaps with both the two adjacent solar panels 130A, 130B. For example, an end 140E1 of the dark insulating layer 140 is partially overlapped with the upper edge of a solar panel 130A, and the other end 140E2 of the dark insulating layer 140 is partially overlapped with another solar panel 130B. To overlap the dark insulating layer 140 with at least a portion of the edge of at least one of the two adjacent solar panels 130A, 130B, the dark insulating layer 140 has a width W1 greater than the width D between the two adjacent solar panels 130 (width D of the separating gap G).

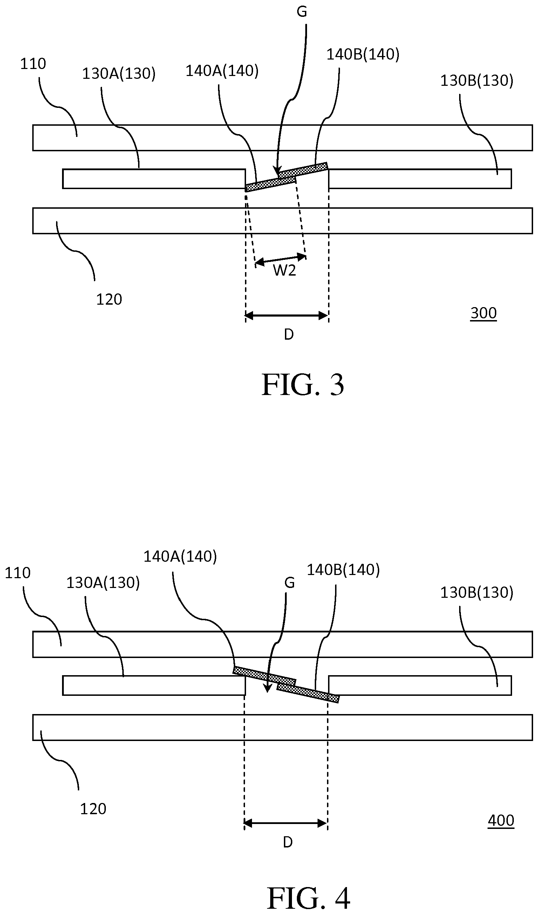

With reference to FIG. 3 for a schematic view of a solar panel module in accordance with a preferred embodiment of the present invention, the solar panel module 300 of this embodiment is substantially the same as the solar panel module 200 as shown in FIG. 2, except that there are two dark insulating layers 140A, 140B in the separating gap G between the two adjacent solar panels 130A, 130B of the solar panel module 300 of this embodiment. One of the dark insulating layers (140B in this case) contacts with the upper edge of one of the solar panels (130B in this case), and the other dark insulating layer 140A contacts with the lower edge of the other solar panel 130A, and these two dark insulating layers 140A, 140B are overlapped with each other. Particularly, each of the dark insulating layers 140A and 140B of this embodiment has a width W2 greater than half of the width D between the two solar panels 130A, 130B. In other words, each of the dark insulating layers 140A, 140B is extended from the edge of one of the corresponsive solar panels 130A, 130B to the separating gap G by a distance, and the distance extended to the separating gap G is greater than half of the width D between the two solar panels 130A, 130B. Therefore, these two dark insulating layers 140A, 140B are overlapped in the separating gap G.

With reference to FIG. 4 for a schematic view of a solar panel module in accordance with another further preferred embodiment of the present invention, the solar panel module 400 of this embodiment is substantially the same as the solar panel module 300 as shown in FIG. 3, except that each of the dark insulating layers 140A, 140B is overlapped with the corresponsive solar panel 130A, 130B of the solar panel module 400 of this embodiment. Specifically, an end of the dark insulating layer 140A has at least a portion overlapped with the upper edge of an end of the solar panel 130A. Similarly, an end of the dark insulating layer 140B has at least a portion overlapped the lower edge of an end of the solar panel 130B. In addition, ends of the dark insulating layers 140A, 140B not overlapped with the solar panels are overlapped with each other.

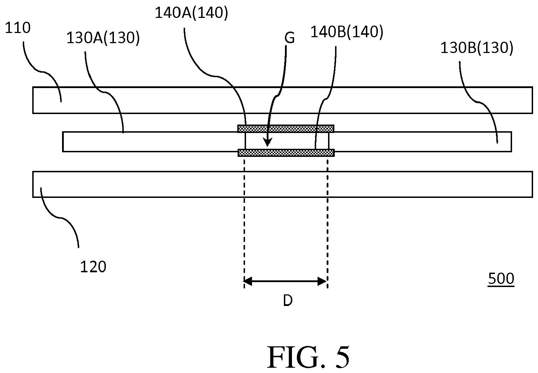

With reference to FIG. 5 for a schematic view of a solar panel module in accordance with a further comparative example, not forming part of the present invention, the solar panel module 500 of this embodiment is substantially the same as the solar panel module 400 as shown in FIG. 4, except that the dark insulating layers 140A, 140B are disposed on both sides of the solar panel 130A, 130B in the solar panel module 500 of this embodiment. Specifically, an end of the dark insulating layer 140A has at least a portion overlapped with the upper edge of an end of the solar panel 130A. The other end of the dark insulating layer 140A has at least a portion overlapped with the upper edge of an end of the other solar panel 130B. Similarly, an end of the dark insulating layer 140B has at least a portion overlapped with the lower edge of the solar panel 130A and the other end of the dark insulating layer 140B has at least a portion overlapped with the lower edge of an end of the other solar panel 130B. In the layout of the dark insulating layer as shown in FIGS. 2 to 5, two portions of the transparent encapsulation materials filled in the separating gap G and disposed at two opposite edges of the dark insulating layer respectively have substantially the same volume, so that their thermal expansion effect is substantially the same, and the reliability can be improved.

In a preferred embodiment, the solar panel module may include a transparent encapsulation material filled in the separating gap, and portions of the transparent encapsulation material disposed at two opposite edges of the dark insulating layer have substantially the same volume.

It is noteworthy that the dark insulating layer 140 of the present invention comes with a color such as a black color or any other appropriate dark color. Further, the color of the dark insulating layer 140 of the present invention is substantially the same as the color of the solar panel 130.

In summation, at least a dark insulating layer is disposed between two adjacent solar panels of the present invention, wherein the dark insulating layer comes with a color substantially the same as the color of the solar panel. Therefore, the dark insulating layer disposed between two adjacent solar panels comes with a degree of heat absorption substantially the same as the degree of heat absorption of the solar panel during the operation of the solar cell, and the solar cell will not be deteriorated by the non-uniform thermal stress. Unlike the conventional solar panel module, the solar panel module of the present invention does not have the issues of poor attachment or peeling condition. In other words, the present invention has better structural connection and reliability and a longer service life.

The dark insulating layer disposed between two adjacent solar panels in accordance with the present invention comes with a color substantially the same as the color of the solar panel, so that there is no significant difference between the degree of heat absorption of the dark insulating layer and the degree of heat absorption of the solar panel. Even in significant thermal expansion and contraction conditions, the present invention will not have the issues of non-uniform thermal stress, deteriorated connection, or peeling situation. In other words, the solar panel of the present invention with a specific structural thickness is capable of maintaining good structural connection and reliability in significant thermal expansion and contraction conditions and extending the service life of the solar cell effectively.

## Claims

1. A solar panel module (300, 400), comprising:
a cover (110);
a back plate (120);
at least two solar panels (130A, 130B) sandwiched between the cover (110) and the back plate (120) and arranged along a direction, and having a separating gap (G) of a width (D) formed between two adjacent solar panels (130A, 130B);
a first dark insulating layer (140A), disposed in the separating gap (G) and contacting an upper edge of one of the two adjacent solar panels (130A) without contacting the other one of the two adjacent solar panels (130B);
a second dark insulating layer (140B), disposed in the separating gap (G) and contacting a lower edge of the other one of the two adjacent solar panels (130B) without contacting the one of the two adjacent solar panels (130A).
wherein the first and second dark insulating layers (140A, 140B) have a color substantially the same as a color of the two adjacent solar panels (130A, 130B),
wherein the first and second dark insulating layers (140A, 140B) are partially overlapped with each other and each of the first and second dark insulating layers (140A, 140B) has a width greater than a half of the width (D) of the separating gap (G).

2. The solar panel module according to any one of claim 1, wherein the two adjacent solar panels (130A, 130B) are thin-film solar panels made of a material selected from a group consisting of silicon (Si), cadmium telluride (CdTe), copper indium gallium selenium (CIGS) and any combination thereof.

3. The solar panel module according to any one of claims 1-2, wherein the first and second dark insulating layers (140A, 140B) are transparent encapsulation material mixed with a dark insulator.

4. The solar panel module according to any one of claims 1-3, wherein the heat absorption degree of the first and second dark insulating layers (140A, 140B) are substantially the same as the absorption degree of the two adjacent solar panels (130A, 130B).

5. The solar panel module according to any one of claims 1-4, wherein the cover (110) and the back plate (120) are glass plates.

6. The solar panel module according to any one of claims 1-5, further comprising a transparent encapsulation material filled in the separating gap (G), and two portions of the transparent encapsulation material at two opposite edges of the separating gap (G) have substantially the same volume.

## Patentansprüche

1. Ein Solarzellenmodul (100, 200, 300, 400, 500), umfassend:
eine Abdeckung (110);
eine hintere Platte (120);
mindestens zwei Solarzellen (130A, 130B) zwischen der Abdeckung (110) und der hinteren Platte (120) eingeklemmt, in eine Richtung angeordnet sind und eine Trennlücke (G) in einer Breite (D) aufweisen, die zwischen zwei benachbarten Solarzellen (130A, 130B) gebildet ist;
eine erste dunkle Isolierschicht (140A) in der Trennlücke (G) angeordnet ist und mit einem oberen Rand eine der zwei benachbarten Solarzellen (130A) in Berührung kommt, ohne dass diese dabei mit der anderen der beiden benachbarten Solarzellen (130B) in Berührung kommt;
eine zweite dunkle Isolierschicht (140B), die in der Trennlücke (G) angeordnet ist und mit einem unteren Rand der anderen der beiden benachbarten Solarzellen (130B) in Berührung kommt, ohne dass diese dabei mit der anderen der beiden benachbarten Solarzellen (130A) in Berührung kommt,
wobei die ersten und zweiten dunklen Isolierschichten (140A, 140B) eine Farbe aufweisen, die im Wesentlichen jener der beiden benachbarten Solarzellen (130A, 130B) entspricht,
wobei die ersten und zweiten dunklen Isolierschichten (140A, 140B) einander teilweise überlappen und dabei sowohl die ersten als auch die zweiten dunklen Isolierschichten (140A, 140B) eine Breite aufweisen, die größer als die Hälfte der Breite (D) der Trennlücke (G) ist.

2. Das Solarzellenmodul nach einem der Ansprüche 1, wobei die beiden benachbarten Solarzellen (130A, 130B) Dünnschicht-Solarzellen sind und aus einem Material bestehen, die aus einer Gruppe aus Silizium (Si), Kadmiumtellurid (CdTe), Kupfer-Indium-Gallium-Selen (CIGS) und einer beliebigen Kombination dieser ausgewählt sind.

3. Das Solarzellenmodul nach einem der Ansprüche 1-2, wobei die ersten und zweiten dunklen Isolierschichten (140A, 140B) aus einem mit einem dunklen Isoliermaterial gemischtes transparentes Einkapselungsmaterial bestehen.

4. Das Solarzellenmodul nach einem der Ansprüche 1-3, wobei der Wärmeabsorptionsgrad der ersten und zweiten dunklen Isolierschichten (140A, 140B) im Wesentlichen dem Absorptionsgrad der beiden benachbarten Solarzellen (130A, 130B) entspricht.

5. Das Solarzellenmodul nach einem der Ansprüche 1-4, wobei die Abdeckung (110) und die hintere Platte (120) als Glasplatten gebildet sind.

6. Das Solarzellenmodul nach einem der Ansprüche 1-5, weiter umfassend ein transparentes Einkapselungsmaterial, das in die Trennlücke (G) eingefüllt ist, während zwei Anteile des transparenten Einkapselungsmaterials an zwei gegenüberliegenden Rändern der Trennlücke (G) im Wesentlichen dasselbe Volumen aufweisen.

## Revendications

1. Module de cellules solaires (100, 200, 300, 400, 500) comprenant:
un couvercle (110);
une plaque arrière (120);
au moins deux cellules solaires (130A, 130B) sont serrées entre le couvercle (110) et la plaque arrière (120), sont disposées dans une direction et ont un intervalle de séparation (G) dans une largeur (D) qui est entre deux cellules solaires adjacentes (130A, 130B) est formé;
une première couche isolante sombre (140A) est disposée dans la fente de séparation (G), et un bord supérieur de l'une des deux cellules solaires adjacentes (130A) vient en contact sans être en contact avec l'autre des deux cellules solaires adjacentes (130B);
une seconde couche isolante sombre (140B) disposée dans l'espace de séparation (G) et en contact avec un bord inférieur de l'autre des deux cellules solaires adjacentes (130B) sans être en contact avec l'autre des deux cellules solaires adjacentes (130A) Le toucher vient,
dans lequel les première et seconde couches isolantes noires (140A, 140B) ont une couleur sensiblement égale à celle des deux cellules solaires adjacentes (130A, 130B),
dans lequel les première et seconde couches isolantes sombres (140A, 140B) se chevauchent partiellement et les deux première et seconde couches isolantes sombres (140A, 140B) ont une largeur supérieure à la moitié de la largeur (D) de l'intervalle de séparation (G) est.

2. Module de cellules solaires selon la revendication 1, dans lequel les deux cellules solaires adjacentes (130A, 130B) sont des cellules solaires à film mince et sont constituées d'un matériau choisi dans un groupe constitué du silicium (Si), du tellurure de cadmium (CdTe), du cuivre indium gallium. -Selen (CIGS) et toute combinaison de ceux-ci sont sélectionnés.

3. Module de cellule solaire selon l'une quelconque des revendications 1 à 2, dans lequel les première et seconde couches isolantes sombres (140A, 140B) sont constituées d'un matériau d'enrobage transparent mélangé à un matériau isolant sombre.

4. Module de cellule solaire selon l'une quelconque des revendications 1 à 3, dans lequel le degré d'absorption de chaleur des première et seconde couches isolantes sombres (140A, 140B) correspond sensiblement au pouvoir d'absorption des deux cellules solaires adjacentes (130A, 130B).

5. Module de cellule solaire selon l'une quelconque des revendications 1 à 4, dans lequel le couvercle (110) et la plaque arrière (120) sont formés en tant que plaques de verre.

6. Module de cellule solaire selon l'une quelconque des revendications 1 à 5, comprenant en outre un matériau d'enrobage transparent rempli dans ledit espace de séparation (G) tandis que deux parties dudit matériau d'enrobage transparent ont sensiblement le même volume au niveau de deux bords opposés dudit espace de séparation (G).
